(19) Europäisches Patentamt
European Patent Office
Office européen des brevets

(11) **EP 4 749 616 A1**

(12) **EUROPEAN PATENT APPLICATION**
published in accordance with Art. 153(4) EPC

(43) Date of publication:
**27.05.2026 Bulletin 2026/22**

(21) Application number: **23932300.9**

(22) Date of filing: **19.07.2023**

(51) International Patent Classification (IPC):
***G10L 15/22*** *(2006.01)*

(52) Cooperative Patent Classification (CPC):
**A63J 17/00; G10L 15/22; H04R 1/04; H04R 1/20;**
**H05B 47/12**

(86) International application number:
**PCT/CN2023/108231**

(87) International publication number:
**WO 2025/015571 (23.01.2025 Gazette 2025/04)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(72) Inventor: **WU, Ji**
**Shenzhen, Guangdong 518054 (CN)**

(74) Representative: **Zaboliene, Reda**
**Metida**
**Business center Vertas**
**Gyneju str. 16**
**01109 Vilnius (LT)**

(71) Applicant: **Shenzhen Mango Science and**
**Technology**
**Innovation Co., Ltd.**
**Shenzhen, Guangdong 518054 (CN)**

(54) **LIGHTING EFFECT CONTROL METHOD, ELECTRONIC DEVICE, AND STORAGE MEDIUM**

(57)    The present application provides a method for controlling illumination effect, an electronic device and a storage medium. The method includes: obtaining sound signals, and constructing an impulse response filter according to a sound field type of the sound signals; filtering the sound signals by using the impulse response filter and obtaining analog signals; transforming the analog signals and obtaining a plurality of spectrum signals; calculating a target excitation value for each of the plurality of spectrum signals, and calculating human-perceived loudness of each of the plurality of spectrum signals according to the target excitation value; controlling a lighting effect of at least one lighting device according to the human-perceived loudness of the sound signals. The above method is able to improve an accuracy for controlling illumination effect.

FIG.2

**Description**

FIELD

The subject matter herein generally relates to a lighting technology field, in particular, relates to a method for controlling illumination effect, an electronic device and a storage medium.

BACKGROUND

People can associate colors and/or lighting effects based on sounds. When a loudness of a sound is perceived, people get a lighting color and/or lighting effect that matches perceived loudness of a sound. For example, people usually associate loud sounds with bright colors, such as white, yellow, etc. Because high-volume sounds stimulate people's auditory nerves and make people feel excited and happy, and these feelings are similar to the emotional reactions caused by bright colors. In addition, people's brains also combine sound and visual information to form associations with lighting effects.

In related technologies for controlling lighting effects, changes in lighting effects are mainly controlled based on the frequency of sound signals. However, the loudness perception of sound signals by the human auditory system is related to factors such as the amplitude, frequency, sound pressure level, duration, and propagation direction of the sound signal. If the change of the lighting effect is controlled only by the frequency of the sound signal, it does not conform to the subjective perception of the human body and cannot accurately reflect the sound loudness perceived by the human body. As a result, the controlled lighting effect does not match the sound loudness perceived by the user, and the lighting effect cannot be accurately controlled and cannot provide users with a comfortable sensory experience.

SUMMARY

In view of the above, it is necessary to provide a method for controlling illumination effect, an electronic device and a non-transitory storage medium, which solves the technical problem that it does not conform to the subjective perception of the human body and cannot accurately reflect the sound loudness perceived by the human body when the lighting effect is controlled by the frequency of the sound signal.

On the one hand, the present application provides a method for controlling illumination effect comprising: obtaining sound signals, and constructing an impulse response filter according to a sound field type of the sound signals; filtering the sound signals by using the impulse response filter and obtaining analog signals; transforming the analog signals and obtaining a plurality of spectrum signals; calculating a target excitation value for each of the plurality of spectrum signals, and calculating human-perceived loudness of each of the plurality of spectrum signals according to the target excitation value; and controlling a lighting effect of at least one lighting device according to the human-perceived loudness of the sound signals.

The sound loudness or the human-perceived loudness in the embodiments of the present application are subjective loudness. Objective loudness is the amplitude of sound waves. Different from objective loudness, the subjective loudness is the sound loudness subjectively perceived by the human body after the sound signal passes by the human auditory system and nerve organs.

In some embodiments of the present application, constructing an impulse response filter according to a sound field type of the sound signals comprises: in response that the sound field type is a free sound field, constructing a first low-pass filter as the impulse response filter according to a preset cutoff frequency and a preset filter type; or in response that the sound field type is a diffuse sound field, constructing a first filter group as the impulse response filter, the first filter group comprising a plurality of second low-pass filters and high-pass filters, the plurality of second low-pass filters and the high-pass filters being connected in series; or in response that the sound field type is a headphone sound field, constructing a second filter group as the impulse response filter, the second filter group comprising a plurality of second low-pass filters and band-pass filters, the plurality of second low-pass filters and the band-pass filters being connected in series.

In some embodiments of the present application, filtering the sound signals by using the impulse response filter and obtaining analog signals comprises: performing a convolution operation on the impulse response filter and the sound signal, and obtaining the analog signals.

In some embodiments of the present application, transforming the analog signals and obtaining a plurality of spectrum signals comprises: dividing the analog signals into frames and obtaining a plurality of short-term signals; performing a windowing processing on each of the plurality of short-term signals, and performing a Fourier transform on each of the plurality of short-term signals after the windowing processing, and obtaining a spectrum signal of each of the plurality of short-term signals.

In some embodiments of the present application, calculating a target excitation value for each of the plurality of spectrum signals comprises: calculating a center frequency of each of the plurality of spectrum signals, and calculating an equirectangular bandwidth of each of the plurality of spectrum signals according to the center frequency; determining a frequency range corresponding to each of the plurality of spectrum signals according to the center frequency and the equirectangular bandwidth of each spectrum signal; calculating the target excitation value of each of the plurality of spectrum signals according to an effective value power and weight coefficients of each frequency component in the corresponding frequency range of each of the plurality of spectrum signals.

In some embodiments of the present application, calculating human-perceived loudness of each of the plurality of spectrum signals according to the target excitation value comprises: calculating an instantaneous specific loudness of each of target excitation values according to a first comparison result between each of the target excitation values and a first preset threshold, and a second comparison result between each of the target excitation values and a second preset threshold; for the first spectrum signal among the plurality of spectrum signals, using the instantaneous specific loudness of the first spectrum signal as the human-perceived loudness of the first spectrum signal; for any spectrum signal among the plurality of spectrum signals except the first spectrum signal, calculating the human-perceived loudness of any spectrum signal according to the preset configuration value, the instantaneous specific loudness of the any spectrum signal and the human-perceived loudness of the previous spectrum signal of any spectrum signal.

In some embodiments of the present application, controlling a lighting effect of at least one lighting device according to the human-perceived loudness of the sound signals comprises: controlling the lighting effect of the at least one lighting device according to a preset control function and the human-perceived loudness.

In some embodiments of the present application, the method further comprises: generating the human-perceived loudness according to a plurality of preset filters and the analog signals.

On the other hand, the present application provides a device for controlling illumination effect, the device is operated on an electronic device, and the device comprises: an acquisition unit configured to obtain sound signals; and a construction unit configured to construct an impulse response filter according to a sound field type of the sound signals; a processing unit configured to filter the sound signals by using the impulse response filter and obtain analog signals; a transformation unit configured to transform the analog signals and obtain a plurality of spectrum signals; a calculation unit configured to calculate a target excitation value for each of the plurality of spectrum signals, and calculate human-perceived loudness of each of the plurality of spectrum signals according to the target excitation value; and a control unit configured to control a lighting effect of at least one lighting device according to the human-perceived loudness of the sound signals.

On the other hand, the present application provides an electronic device comprising: a storage configured to at least one instruction; and a processor configured to execute the at least one instruction to implement the method for controlling illumination effect.

On the other hand, the present application provides a computer-readable storage medium, wherein the computer-readable storage medium stores at least one instruction, and the at least one instruction is executed by a processor in an electronic device to implement the method for controlling illumination effect.

By the above embodiments, since the pulse filter is constructed according to the sound field type of the sound signal, each impulse response filter is equivalent to the human ear structure in the corresponding sound field. The sound signal is filtered according to the impulse response filter, which simulates the filtering characteristics of the human ear structure on the sound signal, so that the analog signals can accurately reflect the sound perceived by the human body, thereby, the human-perceived loudness calculated through the analog signal can accurately reflect the sound loudness actually perceived by the human body. Controlling the lighting effects of the lighting device according to the human-perceived loudness can make the controlled lighting effects match the sound loudness actually perceived by the user.

BRIEF DESCRIPTION OF THE DRAWINGS

Implementations of the present disclosure will now be described, by way of embodiment, with reference to the attached figures.

FIG. 1 is a running environment diagram of a method for controlling illumination effect provided by an embodiment of the present application.

FIG. 2 is a flowchart of a method for controlling illumination effect provided by an embodiment of the present application.

FIG. 3 is a flowchart of a method for calculating a target incentive value provided by an embodiment of the present application.

FIG. 4 is a flowchart of a method for calculating loudness perceived by human body provided by an embodiment of the present application.

FIG. 5 is a flowchart of a method for controlling illumination effect provided by another embodiment of the present application.

FIG. 6 is a functional module diagram of a device for controlling illumination effect provided by an embodiment of the present application.

FIG. 7 is a structural diagram of one embodiment of an electronic device.

DETAILED DESCRIPTION

It should be noted that "at least one" in present application refers to one or more, and "multiple" refers to two or more than two. "And/or" describes the association of associated objects, indicating that there can be three relationships. For example, A and/or B can mean: A exists alone, A and B exist simultaneously, and B exists alone, and A, B can be singular or plural. The terms "first", "second", "third", "fourth" (if present) in the description, claims and drawings of the application are used to distinguish similar objects, rather than to describe a specific order or sequence.

In the embodiments of the application, words such as "exemplary" or "for example" are used to represent examples, illustrations or explanations. Any embodiment or design described as "exemplary" or "such as" in the embodiments of the application is not to be construed as preferred or advantageous over other embodiments or designs. Rather, use of the words "exemplary" or "such as" is intended to present the concept in a concrete manner. The following embodiments and features in the embodiments may be combined with each other without conflict.

People can associate colors and/or lighting effects based on sounds. When a loudness of a sound is perceived, people get a lighting color and/or lighting effect that matches perceived loudness of a sound. For example, people usually associate loud sounds with bright colors, such as white, yellow, etc. Because high-volume sounds stimulate people's auditory nerves and make people feel excited and happy, and these feelings are similar to the emotional reactions caused by bright colors. In addition, people's brains also combine sound and visual information to form associations with lighting effects.

In related technologies for controlling lighting effects, changes in lighting effects are mainly controlled based on the frequency of sound signals. However, the loudness perception of sound signals by the human auditory system is related to factors such as the amplitude, frequency, sound pressure level, duration, and propagation direction of the sound signal. If the change of the lighting effect is controlled only by the frequency of the sound signal, it does not conform to the subjective perception of the human body and cannot accurately reflect the sound loudness perceived by the human body. As a result, the controlled lighting effect does not match the sound loudness perceived by the user, and the lighting effect cannot be accurately controlled and cannot provide users with a comfortable sensory experience.

In order to solve the above problems, embodiments of the present application provide a method for controlling illumination effect, an electronic device and a storage medium, which will be introduced below with reference to the relevant drawings.

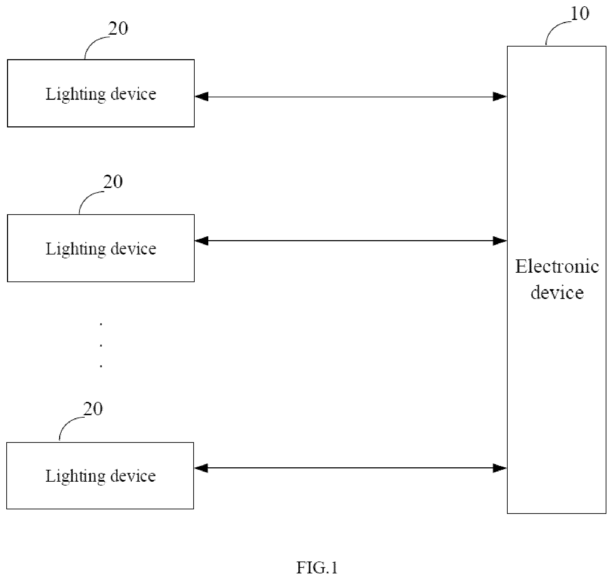

FIG.1 illustrates a running environment diagram of a method for controlling illumination effect provided by an embodiment of the present application. In FIG. 1, an electronic device 10 communicates with a plurality of lighting devices 20 respectively. The electronic device 10 can be connected to the plurality of lighting devices 20 by a Bluetooth module, a hotspot, a Wi-Fi module, etc., so that the electronic device 10 can control the lighting effects of the plurality of lighting devices 20 (such as lighting brightness).

The electronic device 10 may be an electronic device such as a mobile phone, a tablet computer, a notebook computer, etc. The embodiment of the present application does not place any restrictions on the specific type of the electronic device.

The plurality of lighting devices 20 may be a plurality of lamps, for example, lamps using light emitting diodes (LEDs) as light sources, referred to as LED lamps, energy-saving lamps, floodlights, security lamps, lamp strips and lamp beads that present different lighting effects according to different sound loudness, etc. The embodiments of the application do not place any restrictions on the specific types of lighting device.

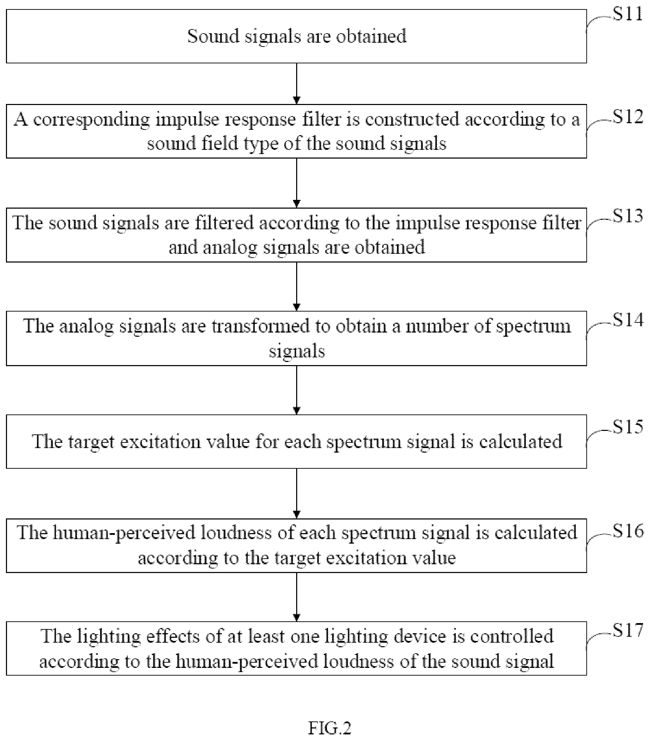

FIG. 2 is a flowchart of a method for controlling illumination effect provided by an embodiment of the present application. The execution subject of the method is an electronic device, such as the electronic device 10 shown in FIG. 2. According to different needs, a sequence of each step in the flowchart can be adjusted according to actual requirements, and some steps can be omitted.

At block S11, sound signals are obtained.

In some embodiments, the electronic device may obtain the sound signals (sound wave signals) from a sound collection device such as a microphone. The sound collection device may also be a microphone, a sound card, a vibration sensor, etc. Since the microphone performs signal processing (such as sampling, quantization, and pulse modulation coding (PCM), etc.) on the collected original signal, the sound signals are digital signals after signal processing.

In other embodiments of the present application, the electronic device may use received audio information digital source file as the sound signals. A format of the audio information digital source file may be a WMA, WAV, APE, FLAC, etc. For example, the electronic device may receive the signals in the audio information digital source file uploaded by the user as the sound signal, and the format of the audio information digital source file is WAV format.

At block S 12, a corresponding impulse response filter is constructed according to a sound field type of the sound signals.

In some embodiments, the sound field type refers to a propagation environment of the sound signals, and the sound field type includes a free sound field, a diffuse sound field, and a headphone sound field. The free sound field refers to an open propagation environment without any reflection or interference, the diffuse sound field refers to a closed propagation environment with reflection and interference, and the headphone sound field refers to the propagation environment created by wearing headphones.

In an embodiment of the present application, if the sound field type is a free sound field, the electronic device constructs a corresponding impulse response filter according to the sound field type of the sound signals, including: the electronic device constructing a first low-pass filter as the impulse response filter according to a preset cutoff frequency and a preset filter type.

The preset cutoff frequency enables the first low-pass filter to only retain signals lower than the preset cutoff frequency when filtering the signals. The preset cutoff frequency can be set by oneself, which is not limited in the application. The preset filter types include, but are not limited to: a Butterworth filter, a Chebyshev filter, an elliptic filter, etc. The first low-pass filter refers to a transfer function. The electronic device is able to use software such as matlab or python to calculate multiple filter coefficients according to the preset cutoff frequency and the preset filter type, and use the transfer function generated by the plurality of filter coefficients as the first low-pass filter. The plurality of filter coefficients include normalized cutoff frequency, filter order, etc.

In another embodiment of the present application, if the sound field type is a diffuse sound field, the electronic device constructing the corresponding impulse response filter according to the sound field type of the sound signals includes: the electronic device constructing a filter group in which a plurality of second low-pass filters and high-pass filters are connected in series as the impulse response filter.

The construction process of the plurality of second low-pass filters is basically the same as the construction process of the first low-pass filter, so the application will not repeat describe the construction process of the plurality of second low-pass filters.

When constructing the high-pass filter, a high-pass cutoff frequency needs to be selected so that the high-pass filter only retains signals higher than the high-pass cutoff frequency when filtering the signals. The high-pass cutoff frequency can be set by yourself, and the application does not impose restrictions on this. The construction process of the high-pass filter can refer to related technologies.

In another embodiment of the present application, if the sound field type is a headphone sound field, the electronic device constructing the corresponding impulse response filter according to the sound field type of the sound signal includes: the electronic device constructing a filter group in which the plurality of second low-pass filters and band-pass filters are connected in series as the impulse response filter.

When constructing the band-pass filter, it is necessary to select a preset upper limit frequency and a preset lower limit frequency so that the band-pass filter only retains the frequency range between the preset upper limit frequency and the preset lower limit frequency when filtering the signal. The preset upper limit frequency and the preset lower limit frequency can be set by oneself, and the application does not limit this. The construction process of the bandpass filter can refer to related technologies.

In the embodiment, since the impulse response filter is constructed according to the sound field type, the impulse response filter is equivalent to the human ear structure in the corresponding sound field.

At block S13, the sound signals are filtered according to the impulse response filter and analog signals are obtained.

In some embodiments, the electronic device performs filtering processing on the sound signal according to the impulse response filter, and obtaining the analog signals includes: the electronic device performing a convolution operation on the impulse response filter and the sound signal and obtaining the analog signals.

In the embodiment, since the impulse response filter is a transfer function, the impulse response filter can perform a convolution operation with the sound signal.

In the embodiment, the sound signals are filtered according to the impulse response filter, which simulates the filtering characteristics of the human ear structure on the sound signals, so that the analog signals can accurately reflect the sound perceived by the human body.

At block S14, the analog signals are transformed to obtain a plurality of spectrum signals.

In some embodiments of the present application, the electronic device transforms the analog signals to obtain the plurality of spectrum signals including: the electronic device dividing the analog signals into frames to obtain the plurality of short-term signals, performing a windowing processing on each short-term signal, and performing a Fourier transform on each short-term signals after the windowing process, to obtain a spectrum signal of each short-term signal.

In one embodiment, the lengths of the plurality of short-term signals may be the same or different, and the number the short-term signals may be set by oneself, which is not limited in the application. For example, the number of short-term signals may be 24.

The electronic device can use a time window function to perform window processing on each short-term signal. The time window function can be a rectangle window function, a Hamming window function, and a Blackman window function, etc. The Fourier transform includes, but is not limited to: a Fast Fourier Transform (FFT), a Short-Time Fourier Transform (STFT), etc. The electronic device performing the windowing processing on each short-term signal includes: multiplying each short-term signal and a time window function and obtaining the windowed short-term signal.

In the embodiment, dividing the analog signal into frames can make each short-term signal more stable and more in line with the periodicity requirements of Fourier transform. Performing windowing processing on each short-term signal is able to reduce a spectrum leakage of the spectrum signal.

In other embodiments of the present application, the electronic device may first perform Fourier transform on the analog signals to obtain initial spectrum signals of the analog signal, and select a target spectrum signal from the initial spectrum signals based on the frequency band range that the human ear can perceive, and divide the target spectrum signal into frames to obtain the plurality of sub-spectrum signals. Then, the electronic device uses the time window function to perform window processing on each sub-spectrum signal to obtain the plurality of spectrum signals.

In one embodiment, the electronic device may select a signal in the frequency band range from the initial spectrum signal as the target spectrum signal. For example, the frequency band range may be 50-15000 HZ, etc. In the process of windowing each sub-spectrum signal by using a time window function, the smaller the frequency band of the sub-spectrum signal, the longer the time window function. The number of the sub-spectrum signals can be set by yourself, and the application does not limit this. For example, the number of the sub-spectrum signals may be 24 or 100.

In the embodiment, a target spectrum signal is selected from the initial spectrum signals based on the frequency band range that the human ear can perceive, and redundant signals are filtered out while ensuring that the target spectrum signal covers the frequency band range that the human ear can perceive, thus, a generation speed of the plurality of spectrum signals can be increased.

At block S15, the target excitation value for each spectrum signal is calculated.

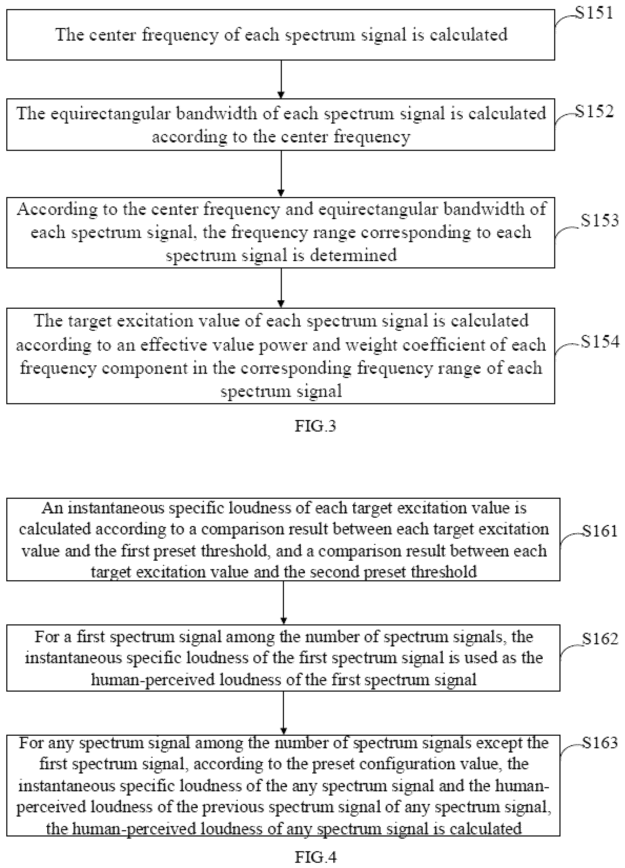

In some embodiments of the present application, each target excitation value is calculated by calculating the power of all frequency components in each spectrum signal by the auditory filter corresponding to each spectrum signal. Each auditory filter refers to a function with respect to the center frequency of each spectral signal. The bandwidth and shape of the auditory filter corresponding to each spectral signal are determined by the center frequency and weight coefficient (or sound pressure level) corresponding to each spectral signal. In one embodiment, the center frequency and the weight coefficient will be described below with respect to the process in FIG. 3.

At block S16, the human-perceived loudness of each spectrum signal is calculated according to the target excitation value.

In some embodiments of the present application, the loudness perceived by the human body refers to the calculated loudness perceived by the human auditory system of the sound signal. Each target excitation value can be converted into a corresponding loudness perceived by the human body through a plurality of preset thresholds. For the specific process, please refer to the description of the process in FIG. 4 below.

At block S17, the lighting effects of at least one lighting device is controlled according to the human-perceived loudness of the sound signal.

In some embodiments of the present application, controlling the lighting effects of at least one lighting device according to the human-perceived loudness of the sound signal includes: the electronic device controlling the lighting effects of the at least one lighting device according to a preset control function and the human-perceived loudness. The human-perceived loudness may be one or more, and the lighting device includes a plurality of lamps, such as lamp beads and lamp strips, for example, the plurality of lighting devices 20 in FIG. 1.

In one embodiment, the preset control function may be a function between the lighting effects and the human-perceived loudness, the dependent variable in the preset control function is the parameter corresponding to the lighting effect, and the independent variable is the parameter corresponding to the human-perceived loudness. By substituting each human-perceived loudness into the preset control function, the target lighting effect corresponding to each human-perceived loudness can be obtained, and then the lighting effects of the at least one lighting device is controlled according to the target lighting effect. In the preset control function, the lighting effects is positively correlated with the human-perceived loudness. The greater the human-perceived loudness, the higher the lighting effects, and the smaller the human-perceived loudness, the lower the lighting effects. For example, the preset control function can be $y=kx$ or $y=k(z-x)$, where $y$ is a parameter corresponding to the lighting effects, $k$ is a preset constant and $k$ is greater than 1, and $x$ is a parameter corresponding to the human-perceived loudness, $z$ can be calculated from multiple historical human-perceived loudness (for example, it can be an average of multiple historical human-perceived loudness).

In other embodiments of the present application, in addition to controlling the lighting effects of the at least one lighting device, the at least one lighting device can also be controlled to emit a specific lighting effect based on the human-perceived loudness. For example, when the human-perceived loudness is greater than or equal to a preset loudness threshold, the electronic device can control the light strip to emit flashing light. Alternatively, when the human-perceived loudness is less than the preset loudness threshold, it is determined that the sound signal is relatively stable, and the electronic device can control the light strip to emit a slow water ripple lighting effect. In addition, for sounds coming from far away, the loudness perceived by the human ear (human-perceived loudness) is small, and for sounds coming from nearby, the loudness perceived by the human ear (human perceived loudness) is large, therefore, for sounds with different propagation distances, the loudness perceived by the human ear will change. When the human ear senses a sound whose perceived loudness changes from small to loud, it will form a sense of oncoming space. Therefore, the lighting effects of the at least one electronic device can be controlled to change according to the change in the human-perceived loudness. For example, when the human-perceived loudness changes from small to loud, the electronic device can control the number of lamp beads that light up from far to near in a unit time to increase, so as to present an oncoming lighting effect that matches the loudness perceived by the human ear, giving the user three-dimensional visual and auditory enjoyment.

In other embodiments of the present application, the at least one lighting device can be controlled by other more control functions to enrich the lighting effects as the human-perceived loudness changes.

In related technologies, loudness level (unit: square) is usually used to describe a subjective perception of sound by the human ear. The greater the loudness level, the louder the sound perceived by the human ear. The human ear's perception of sound is related to multiple factors, such as sound duration, sound pressure level, frequency and timbre, etc.

After research, it has been found that the human ear's perception of sound has the following characteristics: (1) within a certain range, the longer the duration of the sound, the greater the loudness level of the sound perceived by the human ear; (2) for sounds with the same sound pressure level and different frequencies, the sound loudness perceived by the human ear is not the same (the loudness levels are different); in order for the human ears to perceive the sounds of the same loudness level, the required sound pressure levels and frequencies are also different; (3) the human ear's perception of sounds of different frequencies is affected by the sound pressure level. For sounds with different frequencies and sound pressure levels above 80dB, the loudness levels perceived by the human ear are basically the same (when the sound pressure level is high, the loudness perceived by the human ear is basically the same for sounds of various frequencies).

According to the perceptual characteristics of sound by the human ear mentioned above, if relying on the frequency of the sound signal to control the lighting effects of the lighting device, it does not conform to the subjective perception of the human body and cannot accurately reflect the sound loudness perceived by the human ear, causing the controlled lighting effect to be inaccurate. For example, for sound signals with different frequencies and sound pressure levels above 80dB, if the lighting effects of the lighting device is controlled according to the frequency of the sound signal, the lighting effects will change accordingly when the frequency is different. However, based on the above characteristics, it can be seen that for sounds with different frequencies and sound pressure levels above 80dB, the loudness level perceived by the human ear is basically the same, and the lighting effects should not change at this time. Therefore, if the lighting effects are controlled based on the frequency of the sound signal, it does not conform to the subjective perception of the human body.

For a white noise signal that is uniformly mixed with sounds of all different frequencies within the human hearing range (20 Hz - 20000 Hz), its loudness is evenly distributed within the human hearing range (the loudness level perceived by the human ear is basically same), at this time, the changes should be controlled to be gentle and uniform, such as controlling the lighting device to present a slow water rhyme effect, so as to conform to the human body's subjective perception of white noise. However, if the lighting effects of the lighting device are controlled based on the frequency of the sound signal, the lighting effects will change accordingly when the frequency of the white noise is different. Therefore, if the lighting effects are controlled based on the frequency of the sound signal, it does not conform to the subjective perception of the human body.

In order to solve the above technical problem, the sound loudness or the human-perceived loudness in the embodiments of the present application are both subjective loudness. Objective loudness is the amplitude of sound waves. Different from objective loudness, the subjective loudness is the sound loudness subjectively perceived by the human body after the sound signal passes by the human auditory system and nerve organs (the human-perceived loudness is the loudness obtained by simulating the filtering characteristics of the sound signal by the human ear structure), therefore, the human-perceived loudness can accurately reflect the sound loudness actually perceived by the human body. Controlling the lighting effects of the lighting device by accurate human-perceived loudness can improve the control accuracy of lighting effects.

By the above embodiments, since the pulse filter is constructed according to the sound field type of the sound signal, each impulse response filter is equivalent to the human ear structure in the corresponding sound field. The sound signal is filtered according to the impulse response filter, which simulates the filtering characteristics of the human ear structure on the sound signal, so that the analog signals can accurately reflect the sound perceived by the human body, thereby, the human-perceived loudness calculated through the analog signal can accurately reflect the sound loudness actually perceived by the human body. Controlling the lighting effects of the lighting device according to the human-perceived loudness can make the controlled lighting effects match the sound loudness actually perceived by the user.

In some embodiments of the present application, FIG. 3 is a flowchart of a method for calculating a target incentive value provided by an embodiment of the present application. The method specifically includes the following steps.

At block S151, the center frequency of each spectrum signal is calculated.

In some embodiments of the present application, the electronic device calculates the center frequency of each target spectrum signal from each target spectrum signal at a preset time interval. The preset time interval can be set by oneself, and the application does not limit this. For example, the preset time interval may be 1 ms. The center frequency may be a frequency corresponding to a peak value of each spectrum signal, or the center frequency may be a weighted operation on each spectrum signal to obtain the center frequency of each spectrum signal.

At block S152, the equirectangular bandwidth of each spectrum signal is calculated according to the center frequency.

In some embodiments of the present application, the center frequency is substituted into a preset equirectangular bandwidth calculation formula, thereby obtaining the equirectangular bandwidth. The calculation formula of the equirectangular bandwidth is a function of the center frequency.

For example, the equirectangular bandwidth calculation formula can refer to the following formula (1):

$$ERBc = 24.673(0.004358f_c + 1), (1)$$

Where, *ERBc* represents the equirectangular bandwidth, and $f_c$ represents the center frequency.

At block S153, according to the center frequency and equirectangular bandwidth of each spectrum signal, the frequency range corresponding to each spectrum signal is determined.

In some embodiments of the present application, the electronic device calculates a sum between the center frequency and one-half of the equirectangular bandwidth, and calculates a difference between the center frequency and one-half of the equirectangular bandwidth, and generates the frequency range according to the sum and the difference. For example, if the center frequency is A and the equirectangular bandwidth is B, then the frequency range is [A-B/2, A+B/2].

At block S154, the target excitation value of each spectrum signal is calculated according to an effective value power and weight coefficient of each frequency component in the corresponding frequency range of each spectrum signal.

In some embodiments of the present application, the electronic device calculates a product between the effective value power and the weight coefficient of each frequency component in the corresponding frequency range of each spectrum signal, and determines the sum of multiple products corresponding to each spectrum signal as the target excitation value of each spectrum signal. In one embodiment, the effective value power of each frequency component can be calculated according to the center frequency and equirectangular bandwidth corresponding to the frequency component, and the weight coefficient of each frequency component can be calculated based on the center frequency and effective value power of the frequency component.

For example, the target excitation value can be calculated by a Moore steady-state loudness model. The specific calculation formula can refer to the following formulas (2)-(8):

$$E_c = \frac{\sum_{f_c-ERBc/2}^{f_c+ERBc/2} w_j p_j^2}{p_0^2} E_0; (2)$$

$$w_j = (1 + p_j g_j); (3)$$

if

$$f_j \leq f_c, \quad p_j = \frac{4f_c}{ERBc} - 0.35\left[\left(\frac{4f_c}{30ERBc}\right)(ERBLj - 51)\right]; (4)$$

if

$$f_j > f_c, \quad p_j = \frac{4f_c}{ERBc}; (5)$$

if

$$\frac{|f_j - f_c|}{f_c} \leq 1, \quad g_j = |f_j - f_c|/f_c; (6)$$

if

$$1 < \frac{|f_j - f_c|}{f_c} \le 4, g_j = 1; (7)$$

if

$$\frac{|f_j - f_c|}{f_c} > 4, \quad g_j = 4; (8)$$

where, $E_c$ represents the target excitation value, $w_j$ represents the weight coefficient, and $p_j$ represents the effective value power, $E_0$ represents an output value of a pure tone signal with a frequency of 1000Hz and a sound pressure level of 0dB after passing through an auditory filter with a center frequency of 1000Hz., $p_0$ represents the preset sound pressure level (for example, $2 \times 10\text{-}5\,Pa$), $ERBc$ represents the equirectangular bandwidth, $f_j$ represents the frequency value of the jth frequency component of the spectrum signal in the corresponding frequency range, $f_c$ represents the center frequency, $ERBLj$ represents an input excitation level corresponding to $f_j$, and $ERBLj$ can be calculated with reference to relevant technologies.

In some embodiments of the present application, FIG. 4 is a flowchart of a method for calculating loudness perceived by human body provided by an embodiment of the present application. The method specifically includes the following steps.

At block 161, an instantaneous specific loudness of each target excitation value is calculated according to a comparison result between each target excitation value and the first preset threshold, and a comparison result between each target excitation value and the second preset threshold.

In some embodiments of the present application, the second preset threshold is greater than the first preset threshold. The first preset threshold and the second preset threshold can be set by oneself, which are not limited in the application. For example, the first preset threshold may be 2000, and the second preset threshold may be 1010.

The comparison results include: the target excitation value is less than the first preset threshold, or the target excitation value is greater than or equal to the first preset threshold and less than the second preset threshold, or the target excitation value is greater than the second preset threshold. For different comparison results, different formulas may be used to calculate the instantaneous specific loudness of each target excitation value according to each target excitation value, and each formula may be a function of the target excitation value.

For example, when the target excitation value is less than the first preset threshold, the calculation method of the instantaneous specific loudness of the target excitation value can refer to the following formula (9), or, when the target excitation value is greater than or equal to the first preset threshold and less than the second preset threshold, the calculation method of the instantaneous specific loudness of the target excitation value can refer to the following formula (10), or when the target excitation value is greater than the second preset threshold, the calculation method of the instantaneous specific loudness of the target excitation value may refer to the following formula (11).

$$N' = C\left[\frac{2E_c}{(E_c + E_{THRQ})}\right]^{1.5}\left[\left(\frac{GE_c}{E_0} + A\right)^{\alpha} - A^{\alpha}\right]; (9)$$

$$N' = C\left[\left(\frac{GE_c}{E_0} + A\right)^{\alpha} - A^{\alpha}\right]; (10)$$

$$N' = C\left[\frac{E_c/E_0}{1.0707}\right]^{0.2}; (11)$$

where, N' represents the instantaneous specific loudness, C represents the preset constant, $E_c$ represents the target excitation value, $E_{THRQ}$ represents the first preset threshold, G represents a gain of the auditory filter corresponding to the target excitation value, $E_0$ represents the output value of a pure tone signal with a frequency of 1000Hz and a sound pressure level of 0dB after passing through an auditory filter with a center frequency of 1000Hz, A and $\alpha$ are both preset values related to G.

At block 162, for a first spectrum signal among the plurality of spectrum signals, the instantaneous specific loudness of the first spectrum signal is used as the human-perceived loudness of the first spectrum signal.

In the embodiment, since the perceived loudness of the first spectrum signal among the plurality of spectrum signals is not interfered by other perceived loudness, therefore, the electronic device can directly use the instantaneous specific loudness of the first spectrum signal as the human-perceived loudness of the first spectrum signal.

At block 163, for any spectrum signal among the plurality of spectrum signals except the first spectrum signal, according to the preset configuration value, the instantaneous specific loudness of the any spectrum signal and the human-perceived loudness of the previous spectrum signal of any spectrum signal, the human-perceived loudness of any spectrum signal is calculated.

In some embodiments of the present application, the electronic device calculating the human-perceived loudness of any spectrum signal according to the preset configuration value, the instantaneous specific loudness of the any spectrum signal, and the human-perceived loudness of the previous spectrum signal of any spectrum signal, includes: the electronic device performing a weighted operation on the instantaneous specific loudness of the any spectrum signal and the human-perceived loudness of the previous spectrum signal of any spectrum signal according to the preset configuration value to obtain the human-perceived loudness of any spectrum signal. The preset configuration value can be set by oneself, which is not limited in the application. For example, the preset configuration value is 0.01 or 0.005, etc.

For example, the calculation method of the human-perceived loudness can refer to the following formula (12):

$$N_n' = \alpha_r N_n + (1 - \alpha_r) N_{n-1}'; (12)$$

where, $N_n'$ represents the human-perceived loudness of the nth spectrum signal, and n is greater than or equal to 2, $\alpha_r$ represents the preset configuration value, $N_n$ represents the instantaneous specific loudness of the nth spectrum signal, and $N_{n-1}'$ represents the human-perceived loudness of the spectrum signal of the (n-1)th spectrum signal.

In one embodiment, the preset configuration value can be set by oneself, which is not limited in the application. For example, the preset configuration value may be 0.01.

In the embodiment, since the perceived loudness of any spectrum signal among the plurality of spectrum signals except the first spectrum signal will be affected by the instantaneous perceived loudness of the previous spectrum signal, therefore, for any spectrum signal among the plurality of spectrum signals except the first spectrum signal, calculating the human-perceived loudness of any spectrum signal by a weighted operation can improve the accuracy of the human body perceived loudness.

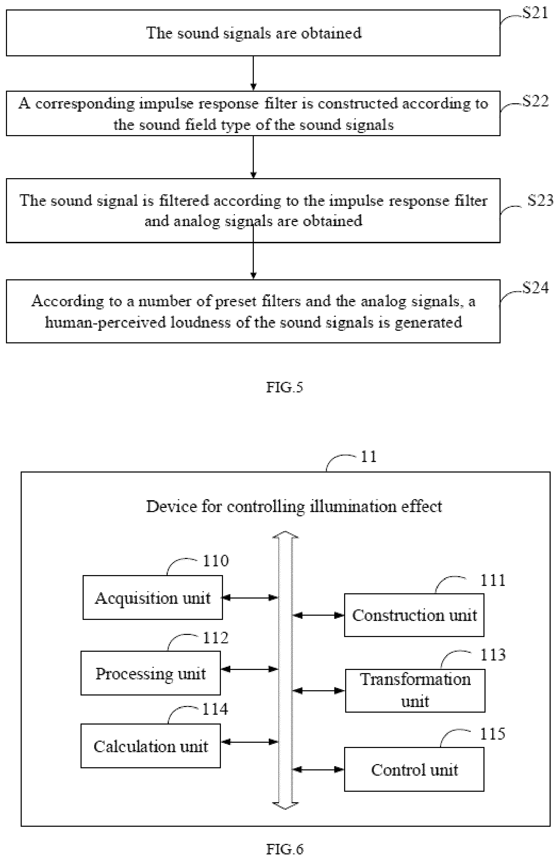

As shown in FIG. 5, it is a flowchart of a method for controlling illumination effect provided by another embodiment of the present application. The execution subject of the method is an electronic device, such as the electronic device 10 shown in FIG. 1. According to different needs, the sequence of each step in the flowchart can be adjusted according to actual requirements, and some steps can be omitted.

At block 21, the sound signals are obtained.

In some embodiments, the sound signals are signals processed by signal processing method, such as PCM encoding. The detailed process of obtaining the sound signal can be referred to block S11, which will not be described again in the application.

At block 22, a corresponding impulse response filter is constructed according to the sound field type of the sound signals.

In some embodiments, the sound field type refers to the propagation environment of the sound signal, and the sound field type includes a free sound field, a diffuse sound field, and a headphone sound field. For the detailed process of constructing the impulse response filter corresponding to the sound field type, please refer to block S12 above.

At block 23, the sound signal is filtered according to the impulse response filter and analog signals are obtained.

In some embodiments, the electronic device performing filtering processing on the sound signal according to the impulse response filter, and obtaining the analog signal includes: the electronic device performing a convolution operation on the impulse response filter and the sound signal to obtain the analog signals.

In the embodiment, since the impulse response filter is a transfer function, it can perform a convolution operation with the sound signal.

At block 24, according to a plurality of preset filters and the analog signals, a human-perceived loudness of the sound signals is generated.

In some embodiments, the plurality of preset filters include, but are not limited to: second-order filters, square filters, smoothing filters, etc. The plurality of preset filters can be set in advance, and the application does not limit these.

In some embodiments of the present application, the electronic device generates the human-perceived loudness of the sound signal according to the plurality of preset filters and the analog signals, includes: dividing the analog signals into frames to obtain a plurality of first signals. using the second-order filter to perform signal extraction on each first signal to obtain a second signal corresponding to each first signal; using the square filter to perform filtering processing on each second signal to obtain the third signal corresponding to each second signal; and using the smoothing filter to perform weighted average processing on each third signal to obtain the human-perceived loudness of each third signal, thereby obtaining the human-perceived loudness of the sound signal. The human-perceived loudness may be one or more.

In one embodiment, the second-order filter may be configured in advance, so that a second signal in a predetermined frequency range can be extracted from each first signal, and the second-order filters are multiple. The square filter can filter out noise in each second signal, and the smoothing filter can reduce the noise in each third signal by performing weighted average processing on each third signal and using a weighted average as the output value, thus reducing the noise and fluctuation in each third signal.

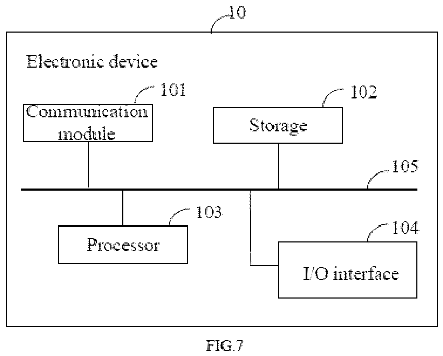

FIG. 6 is a functional module diagram of a device for controlling illumination effect provided by an embodiment of the present application. The device 11 for controlling illumination effect includes an acquisition unit 110, a construction unit 111, a processing unit 112, a transformation unit 113, a calculation unit 114 and a control unit 115. The module/unit referred to in the application refers to a series of computer-readable instruction segments that can be acquired by the processor 13 in FIG. 7 and can complete a fixed function, which are stored in the storage 12 in FIG. 7. In the embodiment, the functions of each module/unit will be described in detail in subsequent embodiments.

The acquisition unit 110 is used to obtain sound signals.

The construction unit 111 is used to construct a corresponding impulse response filter according to a sound field type of the sound signals.

In some embodiments of the present application, if the sound field type is a free sound field, the construction unit 111 is further used to construct a first low-pass filter as the impulse response filter according to a preset cutoff frequency and a preset filter type.

In some embodiments of the present application, if the sound field type is a diffuse sound field, the construction unit 111 is further used to construct a filter group, in which a plurality of second low-pass filters and high-pass filters are connected in series as the impulse response filter.

In some embodiments of the present application, if the sound field type is a headphone sound field, the construction unit 111 is further used to construct a filter group in which the plurality of second low-pass filters and band-pass filters are connected in series as the impulse response filter.

The processing unit 112 is used to filter the sound signals according to the impulse response filter and obtain the analog signals.

In some embodiments of the present application, the processing unit 112 is further used to perform a convolution operation on the impulse response filter and the sound signal and obtain the analog signals.

The transformation unit 113 is used to transform the analog signals to obtain a plurality of spectrum signals.

In some embodiments of the present application, the transformation unit 113 is further used to divide the analog signals into frames to obtain the plurality of short-term signals, perform a windowing processing on each short-term signal, and perform a Fourier transform on each short-term signals after the windowing process, to obtain a spectrum signal of each short-term signal.

The calculation unit 114 is used to calculate the target excitation value for each spectrum signal, and calculate the human-perceived loudness of each spectrum signal according to the target excitation value.

In some embodiments of the present application, the calculation unit 114 is further used to calculate a center frequency of each spectrum signal, and calculate the equirectangular bandwidth of each spectrum signal according to the center frequency; determine a frequency range corresponding to each spectrum signal according to the center frequency and equirectangular bandwidth of each spectrum signal; calculate the target excitation value of each spectrum signal according to the effective value power and weight coefficient of each frequency component in the corresponding frequency range of each spectrum signal.

In some embodiments of the present application, the calculation unit 114 is further used to calculate the instantaneous specific loudness of each target excitation value according to the comparison result between each target excitation value and the first preset threshold, and the comparison result between each target excitation value and the second preset threshold; for the first spectrum signal among the plurality of spectrum signals, use the instantaneous specific loudness of the first spectrum signal as the human-perceived loudness of the first spectrum signal; for any spectrum signal among the plurality of spectrum signals except the first spectrum signal, according to the preset configuration value, the instantaneous specific loudness of the any spectrum signal and the human-perceived loudness of the previous spectrum signal of any spectrum signal, calculate the human-perceived loudness of any spectrum signal.

The control unit 115 is used to control the lighting effects of at least one lighting device according to the human-perceived loudness of the sound signal.

In some embodiments of the application, the control unit 115 is further used to control the lighting effects of the at least one lighting device according to a preset control function and the human-perceived loudness.

In some other embodiments of the present application, the calculation unit 114 further includes a generation subunit. The generation subunit is used to generate the human-perceived loudness according to a plurality of preset filters and the analog signals.

FIG. 7 is a structural diagram of one embodiment of an electronic device. The electronic device 10 shown in FIG. 7 may include a communication module 101, a storage 102, a processor 103, an input/output (I/O) interface 104 and a bus 105. The processor 103 is coupled to the communication module 101, the storage 102, and the input/output interface 104 by the bus 105, respectively.

The communication module 101 may include a wired communication module and/or a wireless communication module. The wired communication module can provide one or more wired communication solutions such as universal serial bus (USB) and controller area network (CAN). Wireless communication modules can provide one or more of wireless fidelity (Wi-Fi), Bluetooth (BT), mobile communication network, frequency modulation (FM), near field communication (NFC), infrared (IR) communication solutions.

The storage 102 may include one or more random access memories (RAM) and one or more non-volatile memories (NVM). The random access memory can be directly read and written by the processor 103, and can be used to store executable programs (such as machine instructions) or other running programs, and can also be used to store user and application data, etc. Random access memory can include static random-access memory (SRAM), dynamic random access memory (DRAM), synchronous dynamic random access memory (SDRAM), double data rate synchronous Dynamic random access memory (DDR SDRAM), etc.

The non-volatile memory can also store executable programs and user and application data, etc., and can be loaded into the random access memory in advance for direct reading and writing by the processor 103. The Non-volatile memory can include disk storage devices and flash memory.

The storage 102 is used to store one or more computer programs. One or more computer programs are configured for execution by processor 103. The one or more computer programs include a plurality of instructions. When the plurality of instructions are executed by the processor 103, the method for controlling illumination effect executed on the electronic device 10 can be implemented.

In other embodiments, the electronic device 10 shown in FIG. 6 also includes an external memory interface for connecting to an external memory to expand the storage capacity of the electronic device 10.

The processor 103 may include one or more processing units. For example, the processor 103 may include an application processor (AP), a modem processor, a graphics processing unit (GPU), and an image signal processor. (ISP), controller, video codec, digital signal processor (DSP), and/or neural network processor (NPU), etc. Different processing units can be independent devices or integrated in one or more processors.

The processor 103 provides computing and control capabilities. For example, the processor 103 is used to execute a computer program stored in the storage 102 to implement the above method for controlling illumination effect.

The input/output interface 104 is used to provide a channel for user input or output. For example, the input/output interface 104 can be used to connect various input and output devices, such as a mouse, keyboard, touch device, display screen, etc., so that the user can enter information, or visualize information.

The bus 105 is used to provide a channel for mutual communication among the communication module 101, the memory 102, the processor 103, and the input/output interface 104 in the electronic device 10.

It can be understood that the structure illustrated in the embodiment of the present application does not constitute a specific limitation on the electronic device 10. In other embodiments of the present application, the electronic device 10 may include more or fewer components than shown in the figures, or some components may be combined, some components may be separated, or some components may be arranged differently. The components illustrated may be implemented in hardware, software, or a combination of software and hardware.

Embodiments of the present application also provide a computer-readable storage medium. A computer program is stored on the computer-readable storage medium. The computer program includes program instructions. The method implemented when the program instructions are executed may refer to the methods in the above-mentioned embodiments of the application.

The computer-readable storage medium may be an internal memory of the electronic device described in the above embodiment, such as a hard disk or memory of the electronic device. The computer-readable storage medium may also be an external storage device of the electronic device, such as a plug-in hard disk, a smart memory card (SMC), or a secure digital (SD), Flash Card, etc.

In some embodiments, the computer-readable storage medium may include a storage program area and a storage data area, wherein the storage program area may store an operating system, at least one application program required for a function, etc.; the storage data area may store electronic data according to data created by the use of the device, etc.

In the several embodiments provided in the application, it should be understood that the disclosed systems, devices and methods can be implemented in other ways. For example, the device embodiments described above are only illustrative. For example, the division of modules is only a logical function division, and there may be other division methods in actual implementation.

Modules described as separate components may or may not be physically separated, and components shown as modules may or may not be physical units, that is, they may be located in one place, or they may be distributed to multiple network units. Some or all of the modules can be selected according to actual needs to achieve the purpose of the solution of the embodiments. In addition, each functional module in various embodiments of the present application can be integrated into one processing unit, or each unit can exist physically alone, or two or more units can be integrated into one unit. The above-mentioned integrated unit can be implemented in the form of hardware or in the form of hardware plus software function modules.

Therefore, the embodiments should be regarded as illustrative and non-restrictive from any point of view, and the scope of the application is defined by the appended claims rather than the above description. Therefore, all changes within the meaning and range of equivalency of the claims are intended to be embraced in this application. Any accompanying reference signs in the claims shall not be construed as limiting the claim in question. Furthermore, it is clear that the word "comprising" does not exclude other elements or steps, and the singular does not exclude the plural. Multiple units or devices stated in the application may also be implemented by one unit or device by software or hardware. The words first, second, etc., are used to indicate names and do not indicate any specific order.

The above description only represents some embodiments of the present disclosure and is not intended to limit the present disclosure, and various modifications and changes can be made to the present disclosure. Any modifications, equivalent substitutions, improvements, etc. made within the spirit and scope of the present disclosure are intended to be included within the scope of the present disclosure.

**Claims**

1. A method for controlling illumination effect comprising:

   obtaining sound signals, and constructing an impulse response filter according to a sound field type of the sound signals;
   filtering the sound signals by using the impulse response filter and obtaining analog signals;
   transforming the analog signals and obtaining a plurality of spectrum signals;
   calculating a target excitation value for each of the plurality of spectrum signals, and calculating human-perceived loudness of each of the plurality of spectrum signals according to the target excitation value; and
   controlling a lighting effect of at least one lighting device according to the human-perceived loudness of the sound signals.

2. The method for controlling illumination effect as recited in claim 1, wherein constructing an impulse response filter according to a sound field type of the sound signals comprises:

   in response that the sound field type is a free sound field, constructing a first low-pass filter as the impulse response filter according to a preset cutoff frequency and a preset filter type; or
   in response that the sound field type is a diffuse sound field, constructing a first filter group as the impulse response filter, the first filter group comprising a plurality of second low-pass filters and high-pass filters, the plurality of second low-pass filters and the high-pass filters being connected in series; or
   in response that the sound field type is a headphone sound field, constructing a second filter group as the impulse response filter, the second filter group comprising a plurality of second low-pass filters and band-pass filters, the plurality of second low-pass filters and the band-pass filters being connected in series.

3. The method for controlling illumination effect as recited in claim 2, wherein filtering the sound signals by using the impulse response filter and obtaining analog signals comprises:
   performing a convolution operation on the impulse response filter and the sound signal, and obtaining the analog signals.

4. The method for controlling illumination effect as recited in claim **1,** wherein transforming the analog signals and obtaining a plurality of spectrum signals comprises:

   dividing the analog signals into frames and obtaining a plurality of short-term signals;
   performing a windowing processing on each of the plurality of short-term signals, and performing a Fourier transform on each of the plurality of short-term signals after the windowing processing, and obtaining a spectrum signal of each of the plurality of short-term signals.

5. The method for controlling illumination effect as recited in claim **1,** wherein calculating a target excitation value for each of the plurality of spectrum signals comprises:

   calculating a center frequency of each of the plurality of spectrum signals, and calculating an equirectangular bandwidth of each of the plurality of spectrum signals according to the center frequency;
   determining a frequency range corresponding to each of the plurality of spectrum signals according to the center frequency and the equirectangular bandwidth of each spectrum signal;

calculating the target excitation value of each of the plurality of spectrum signals according to an effective value power and weight coefficients of each frequency component in the corresponding frequency range of each of the plurality of spectrum signals.

6. The method for controlling illumination effect as recited in claim **1,** wherein calculating human-perceived loudness of each of the plurality of spectrum signals according to the target excitation value comprises:

calculating an instantaneous specific loudness of each of target excitation values according to a first comparison result between each of the target excitation values and a first preset threshold, and a second comparison result between each of the target excitation values and a second preset threshold;
for the first spectrum signal among the plurality of spectrum signals, using the instantaneous specific loudness of the first spectrum signal as the human-perceived loudness of the first spectrum signal;
for any spectrum signal among the plurality of spectrum signals except the first spectrum signal, calculating the human-perceived loudness of any spectrum signal according to the preset configuration value, the instantaneous specific loudness of the any spectrum signal and the human-perceived loudness of the previous spectrum signal of any spectrum signal.

7. The method for controlling illumination effect as recited in claim **1,** wherein controlling a lighting effect of at least one lighting device according to the human-perceived loudness of the sound signals comprises:
controlling the lighting effect of the at least one lighting device according to a preset control function and the human-perceived loudness.

8. The method for controlling illumination effect as recited in claim **1,** further comprising:
generating the human-perceived loudness according to a plurality of preset filters and the analog signals.

9. An electronic device comprising:

a storage configured to at least one instruction; and
a processor configured to execute the at least one instruction to implement the method for controlling illumination effect as recited in any one of claims 1 to 8.

10. A computer-readable storage medium, wherein the computer-readable storage medium stores at least one instruction, and the at least one instruction is executed by a processor in an electronic device to implement the method for controlling illumination effect as recited in any one of claims 1 to 8.

FIG.1

| Sound signals are obtained | ⌐S11 |

| A corresponding impulse response filter is constructed according to a sound field type of the sound signals | ⌐S12 |

| The sound signals are filtered according to the impulse response filter and analog signals are obtained | ⌐S13 |

| The analog signals are transformed to obtain a number of spectrum signals | ⌐S14 |

| The target excitation value for each spectrum signal is calculated | ⌐S15 |

| The human-perceived loudness of each spectrum signal is calculated according to the target excitation value | ⌐S16 |

| The lighting effects of at least one lighting device is controlled according to the human-perceived loudness of the sound signal | ⌐S17 |

FIG.2

The center frequency of each spectrum signal is calculated — S151

The equirectangular bandwidth of each spectrum signal is calculated according to the center frequency — S152

According to the center frequency and equirectangular bandwidth of each spectrum signal, the frequency range corresponding to each spectrum signal is determined — S153

The target excitation value of each spectrum signal is calculated according to an effective value power and weight coefficient of each frequency component in the corresponding frequency range of each spectrum signal — S154

FIG.3

An instantaneous specific loudness of each target excitation value is calculated according to a comparison result between each target excitation value and the first preset threshold, and a comparison result between each target excitation value and the second preset threshold — S161

For a first spectrum signal among the number of spectrum signals, the instantaneous specific loudness of the first spectrum signal is used as the human-perceived loudness of the first spectrum signal — S162

For any spectrum signal among the number of spectrum signals except the first spectrum signal, according to the preset configuration value, the instantaneous specific loudness of the any spectrum signal and the human-perceived loudness of the previous spectrum signal of any spectrum signal, the human-perceived loudness of any spectrum signal is calculated — S163

FIG.4

The sound signals are obtained ⌐S21

A corresponding impulse response filter is constructed according to the sound field type of the sound signals ⌐S22

The sound signal is filtered according to the impulse response filter and analog signals are obtained ⌐S23

According to a number of preset filters and the analog signals, a human-perceived loudness of the sound signals is generated ⌐S24

FIG.5

⌐11

Device for controlling illumination effect

⌐110
Acquisition unit

⌐111
Construction unit

⌐112
Processing unit

⌐113
Transformation unit

⌐114
Calculation unit

⌐115
Control unit

FIG.6

FIG.7

## INTERNATIONAL SEARCH REPORT

| International application No. |
|---|
| **PCT/CN2023/108231** |

| A. | CLASSIFICATION OF SUBJECT MATTER |
|---|---|

G10L 15/22(2006.01)i

According to International Patent Classification (IPC) or to both national classification and IPC

| B. | FIELDS SEARCHED |
|---|---|

Minimum documentation searched (classification system followed by classification symbols)

IPC: G10L 15/-

Documentation searched other than minimum documentation to the extent that such documents are included in the fields searched

Electronic data base consulted during the international search (name of data base and, where practicable, search terms used)

CNTXT, ENTXTC, ENTXT, CNKI: 芒果科技, 伍吉, 照明, 控制, 响度, 声音, 处理, 脉冲响应滤波, 频谱, 声场类型, 不同声场, 中心频率, 等矩形带宽, loudness, filter+, FIR, frequency, FFT, light+ 2d control+, sound, process

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | CN 108551710 A (PHILIPS LIGHTING HOLDING B.V.) 18 September 2018 (2018-09-18) description, paragraphs [0019]-[0020] and [0027]-[0032], and figures 2 and 4 | 1-10 |
| Y | CN 109297583 A (BEIJING INSTITUTE OF TECHNOLOGY) 01 February 2019 (2019-02-01) description, paragraphs [0008]-[0081] and [0098] | 1-10 |
| A | CN 115315051 A (HANGZHOU EBOYLAMPELETRONICS CO., LTD.) 08 November 2022 (2022-11-08) entire document | 1-10 |
| A | CN 115315050 A (HANGZHOU EBOYLAMPELETRONICS CO., LTD.) 08 November 2022 (2022-11-08) entire document | 1-10 |
| A | CN 106162432 A (WU FAGONG) 23 November 2016 (2016-11-23) entire document | 1-10 |
| A | CN 207625841 U (SHANGHAI HUIGUAN EXHIBITION DESIGN & ENGINEERING CO., LTD.) 17 July 2018 (2018-07-17) entire document | 1-10 |

☑ Further documents are listed in the continuation of Box C. ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **14 November 2023** | **17 November 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/108231**

| C. | DOCUMENTS CONSIDERED TO BE RELEVANT | |
|---|---|---|
| Category* | Citation of document, with indication, where appropriate, of the relevant passages | Relevant to claim No. |
| A | JP 2010078986 A (HITACHI LTD.) 08 April 2010 (2010-04-08)<br>entire document | 1-10 |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| CN | 108551710 | A | 18 September 2018 | JP | 2015501522 | A | 15 January 2015 |
| | | | | JP | 6143768 | B2 | 07 June 2017 |
| | | | | US | 2015002046 | A1 | 01 January 2015 |
| | | | | US | 9642221 | B2 | 02 May 2017 |
| | | | | EP | 2749139 | A1 | 02 July 2014 |
| | | | | EP | 2749139 | B1 | 06 January 2021 |
| | | | | WO | 2013076606 | A1 | 30 May 2013 |
| | | | | CN | 103918353 | A | 09 July 2014 |
| | | | | CN | 108551710 | B | 22 October 2021 |
| CN | 109297583 | A | 01 February 2019 | CN | 109297583 | B | 24 July 2020 |
| CN | 115315051 | A | 08 November 2022 | None | | | |
| CN | 115315050 | A | 08 November 2022 | None | | | |
| CN | 106162432 | A | 23 November 2016 | None | | | |
| CN | 207625841 | U | 17 July 2018 | None | | | |
| JP | 2010078986 | A | 08 April 2010 | JP | 4779000 | B2 | 21 September 2011 |

Form PCT/ISA/210 (patent family annex) (July 2022)